# EUROPEAN PATENT SPECIFICATION

(11) **EP 1 734 408 B1**
(45) Date of publication and mention of the grant of the patent: **17.12.2008**
(21) Application number: 06115073.6
(22) Date of filing: 07.06.2006
(51) Int. Cl.: G03F 7/20, G01J 1/42, G21K 1/06

(54) **Measurement setup with improved sensor lifetime, in particular for measuring EUV energy**
Messeinrichtung mit verlängerter Sensorlebensdauer, insbesondere zum Messen von EUV-Energie
Système de mesure avec amélioration de la durée de vie du capteur en particulier pour mesurer l'énergie EUV

(30) Priority: 14.06.2005 EP 05105212
(43) Date of publication of application: 20.12.2006
(73) Proprietor: Philips Intellectual Property & Standards GmbH, 20099 Hamburg (DE); Koninklijke Philips Electronics N.V., 5621 BA Eindhoven (NL)
(72) Inventor: Jonkers, Jeroen Philips Intellectual Property & St, 52066, Aachen (DE); Vaudrevange, Dominik Philips Intellectual Property & St, 52066, Aachen (DE)
(74) Representative: Volmer, Georg

(56) References cited:
- WO-A2-20/04104707
- DE-B3- 10 237 901

## Description

The present invention relates to a measurement setup for measuring radiation energy, in particular of EUV-radiation and/or soft X-rays, comprising a debris mitigation unit with several passages allowing a straight pass of incoming radiation and a radiation-sensitive element delivering an electrical signal dependent on an energy of incident radiation, wherein said radiation-sensitive element is arranged to measure a fraction of said incoming radiation after passing said debris mitigation unit at least partly. The present invention also relates to an EUV radiation unit comprising such a measurement setup.

The proposed measurement setup is used to measure the energy of incident radiation, in particular of radiation of an EUV-radiation source. EUV radiation units can be used in the field of EUV lithography for fabricating semiconductor devices with structures having dimensions of only a few nanometers. The output of known EUV-radiation sources however is not stable enough to fulfill the dose specifications of a lithography apparatus. The pulse-to-pulse standard deviation is typically only in the range of 10%, whereas the dose stability for EUV lithography should be below 0.33%. The EUV-radiation is generated by a plasma discharge which forms the radiation source of the irradiation unit. The dose stability of such an EUV-radiation source can be improved when the EUV energy of each shot is measured and is used in a feedback loop to control, for instance, the discharge energy.

WO 03/017005 A1 discloses a radiation energy sensor for use in a EUV radiation unit. Such a sensor consists of a photodiode in combination with a bandpass filter to remove UV light, visible light and infrared light. The detector furthermore comprises two multilayer mirrors to further limit the desired wavelength range to a 2 to 2.5 % bandwidth around 13.5 nm.

EUV-radiation sources however, apart from the desired radiation, also emit charged or uncharged particles which can deposit on optical surfaces of the illumination optics of the irradiation unit as well as on the surfaces of a sensor measuring the radiation energy. The total of such undesired particle emissions of an EUV-radiation source is called debris. A principal problem when monitoring the radiation energy close to an EUV-radiation source is the contamination of the sensor surfaces with such debris. Known energy sensors for EUV-radiation as that of WO 03/017005 A1 contain elements like mirrors and filters which are damaged by the debris produced by the EUV-radiation source. Most efficient EUV-radiation sources use tin vapor for plasma generation. From such plasma roughly 10¹⁵ atoms/sr/pulse in the form of fast ions, slow atoms/ions and tiny droplets are emitted in all directions. Assuming a 1 m distance between the source and the sensor, a 10 nm thick layer of tin will be deposited on the first element of the sensor in less than 10⁶ pulses, i.e. in only a couple of minutes, if no mitigation is applied. The transmission of 10 nm of tin is only 50% for EUV-radiation.

The same problem arises for the first mirror facing the EUV-radiation source, the so called collector in an EUV radiation unit. For this case it is known to provide a debris mitigation unit, for example a foil trap, having several passages allowing a straight pass of radiation between the radiation source and the collector mirror. Furthermore, a buffer gas essentially transparent to EUV-radiation is supplied between the radiation source and the debris mitigation unit in order to slow down or stop atomic particles of the debris. If the gas density can be chosen high enough also fast ions are slowed down.

US 2004/0135517 A1 discloses a setup comprising a debris mitigation unit between the EUV-radiation source and the radiation energy sensor. With such a setup the amount of atoms and ions of the debris moving from the radiation source to the sensor is reduced.

In order to also reduce the amount of droplets moving from the radiation source to the collector, it is also known to provide a rotating debris mitigation unit as described in DE 102 37 901 and WO 2004/104707. Due to the rotation the slow droplets collide with the walls of the passages, in particular the foils of a foil trap, so that they cannot pass the mitigation unit. Unfortunately, this solution cannot be applied to a setup as that of the document mentioned before without deteriorating the accuracy of the measurement. The sensitive area of an EUV photodiode has typical dimensions of 1 cm². The foils of a foil trap are typically 0.1 mm thick and have a mutual distance of around 2 mm. If the photodiode is located behind the rotating mitigation unit on average 5 foils will be in front of it and partly block the EUV radiation. However, depending on the time of measurement it is also possible that only 4 or even 6 foils will block the EUV radiation. In other words, behind a rotating foil trap the EUV pulse energy cannot be measured within the specified accuracy of 0.33%.

An object of the present invention is to provide a measurement setup for measuring radiation energy, in particular of EUV radiation and/or soft X-rays, which has an improved protection against debris and allows accurate measurements.

The object is achieved with the measurement setup according to present claim 1. Claim 8 relates to an EUV radiation unit including such a measurement setup. Advantageous embodiments of the measurement setup are the subject matter of the dependent claims or are disclosed in the subsequent description.

The proposed measurement setup comprises a debris mitigation unit with several passages allowing a straight pass of incoming radiation and a radiation-sensitive element delivering an electrical signal dependent on an energy of incident radiation. Said radiation-sensitive element is arranged to measure a fraction of said incoming radiation after passing said debris mitigation unit at least partly. This means that the radiation-sensitive element can be arranged outside or inside said debris mitigation unit. In the measurement setup of the present invention the debris mitigation unit is mounted allowing a rotation around a central axis of said debris mitigation unit during operation. The radiation-sensitive element and/or one or several mirrors guiding said fraction of said incoming radiation to the radiation-sensitive element is/are fixed to the rotating debris mitigation unit.

In the measurement setup of the present invention a rotating debris mitigation unit is used so that also droplets emitted by a plasma source as the radiation source are stopped in that unit and cannot contaminate the surfaces of the radiation-sensitive element. This significantly enhances the lifetime the measuring sensor, i.e. of the radiation-sensitive element and of mirrors or filters possibly in front of said element. On the other hand, due to the fixation of the guiding mirror(s) and/or of the radiation-sensitive element itself on the rotating debris mitigation unit, the radiation-sensitive element only sees the same fraction of incoming radiation independent of the time of measuring. Therefore, an inaccuracy of the measurement caused by the above described rotational effect does not occur.

If the radiation-sensitive element is directly fixed to the rotating debris mitigation unit, the electrical signal can be transferred, for instance, via an opto-coupler located on the central axis of the debris mitigation unit. The necessary supply voltage can be delivered, for instance, via sliding contacts or inductively.

The radiation-sensitive element can be a photodiode as already known from the documents of the prior art described before. The debris mitigation unit is preferably a foil trap as also already known in the art. In a preferred embodiment the foil trap comprises a plurality of single foils extending in a radial direction from said central axis which forms the rotation axis. Preferably the debris mitigation unit also comprises at least one gas supply unit for supply of a buffer gas inside the debris mitigation unit and/or between said debris mitigation unit and a radiation source emitting said radiation, in order to slow down or stop debris particles by collision with the gas atoms.

In a further preferred embodiment which can also be combined with one or several of the previous embodiments, in particular for use in an EUV radiation unit, at least two multilayer mirrors are attached to the rotating debris mitigation unit, whereas the radiation-sensitive element is mounted stationary in continuation of the central axis.

One of the mirrors is fixed on this central axis in order to direct a fraction of the radiation passing through the debris mitigation unit to said radiation-sensitive element. With the use of appropriate multilayer mirrors, a limitation of the bandwidth to 2.5% around the desired wavelength of 13.5 nm for monitoring EUV-radiation in an EUV radiation unit can be achieved. In addition to these multilayer mirrors a suitable bandpass filter for blocking UV light, visible light and/or infrared light can be arranged in front of said radiation-sensitive element. The bandpass filter can also be coated directly on top of the radiation-sensitive element.

In the present description and claims the word "comprising" does not exclude other elements or steps and neither does "a" or "an" exclude a plurality. Also any reference signs in the claims shall not be construed as limiting the scope of these claims.

The measurement setup of the present invention as well as an EUV radiation unit are also described by way of example in connection with the following drawings without limiting the scope of the claims. The figures show:
- Fig. 1: a schematic view of an EUV radiation unit; and
- Fig. 2: a schematic view of an example of the proposed measurement setup.

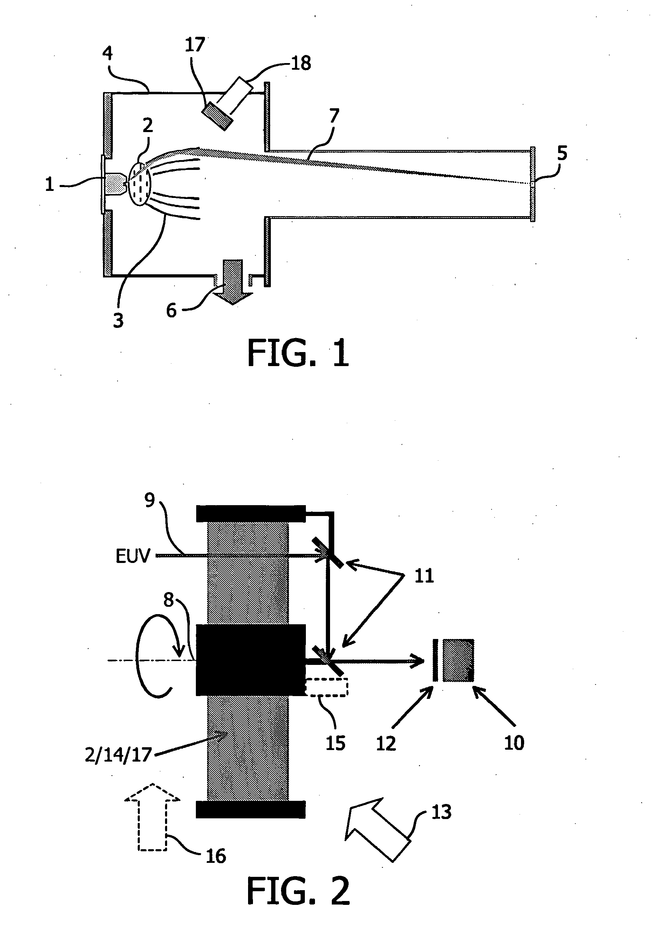

Fig. 1 shows an example of an EUV radiation unit in EUV lithography systems. The unit basically consists of the radiation source 1 and a collector mirror 3 in a vacuum vessel 4. The radiation emitted by the radiation source 1 is collected by the reflective collector mirror 3 and focused on an intermediate focus 5. At the position of this intermediate focus 5 an aperture connects this part of the irradiation unit with a second part used for EUV lithography. In this second part, not shown in fig. 1, further optical elements are arranged to guide the radiation from the intermediate focus 5 to the mask and the wafer substrate. In order to avoid a rapid contamination of the collector mirror 3 by debris emitted by the radiation source 1, a debris mitigation unit 2 is arranged between the radiation source 1 and the collector mirror 3 as indicated in fig. 1. The vacuum vessel 4 is connected with a pump through gas outlet 6. An energy monitor, not shown in fig. 1, measures the pulse energy of the EUV-radiation 7 in order to control the operation of the radiation source 1 to achieve high dose stability.

The present invention is directed to a special arrangement of a debris mitigation unit and the energy monitor, in particular in an EUV radiation unit as that of figure 1. In one embodiment of the invention, debris mitigation unit 2, arranged between the radiation source 1 and the collector mirror 3 in fig. 1, is used as the above debris mitigation unit of the measurement setup. In another embodiment, also indicated in fig. 1, an additional debris mitigation unit 17 is used as the above debris mitigation unit of the measurement setup. This additional debris mitigation unit 17 can be arranged in the vacuum vessel 4 or, for instance, in a tube 18 connected to the vacuum vessel 4. In this embodiment, the energy monitor may be arranged in said tube 18.

An exemplary measurement setup according to the present invention is shown in fig. 2. This figure shows a foil trap 14 as debris mitigation unit 2 or 17 rotating about a central axis 8. Such a foil trap 14 has passages for a straight pass 9 of EUV radiation. In the figure only one fraction of said EUV radiation passing through the foil trap is indicated. The energy monitor comprises two multilayer mirrors 11 fixed to the rotating foil trap 14, i.e. rotating with foil trap 14, and a fixedly mounted photodiode 10. The multilayer mirrors 11 and the photodiode 10 are arranged such that a fraction of the EUV-radiation passing through the foil trap 14 is directed to the stationary photodiode 10 during the rotation of the foil trap 14. To this end the stationary photodiode 10 is mounted in continuation of the central axis 8 of the foil trap 14 as can be seen in fig. 2. Also one of the multilayer mirrors 11 is arranged on said central axis 8 in order to be able to direct said fraction of said EUV radiation in continuation of the central axis 8 to the photodiode 10. The figure also shows a bandpass filter 12 used to filter out UV and visible light before entering the photodiode 10. This filter 12 can be mounted anywhere in the radiation path behind the rotating foil trap 14 or can be coated directly on top of the photodiode 10.

The rotation frequency of the foil trap 14 is determined by the requirement that the foil trap 14 has to stop droplets with a velocity of at least vₘᵢₙ = 600 m/s and can be calculated from vₘᵢₙ = f*N*h, in which N and h represent the number of foils and their height, i.e. their length along the radiation path of the EUV-radiation, respectively. Assuming h = 100 mm and N = 300 of an exemplary foil trap, for instance a foil trap with foils of 1 mm separation distributed on a circle with 50 mm radius, a rotation frequency of at least 20 Hz is required to stop droplets with a velocity of up to 600 m/s.

In order to slow down the fast ions produced by the radiation source and to optimize the debris mitigation of foil trap 14 an integrated density of at least 2 Pa*m argon (with respect to a temperature of 300 K) is required. This can be easily achieved by flowing argon gas from the back through the foil trap 14 in the direction of the radiation source. Reference sign 13 shows the supply tube of a gas supply unit for applying the argon gas. A differential pumping stage may be implemented between the foil trap 14 and the radiation source 1 to limit the argon load on the radiation source.

Figure 2 also schematically indicates an alternative arrangement of the photodiode with dotted lines. In this alternative arrangement the mirror 11 on the central axis 8 is removed and instead of this the photodiode 15 is fixed to the central axis 8 to receive the fraction of radiation from the remaining mirror 11. The figure also schematically indicates another position of the supply tube 16 of a gas supply unit for applying the argon gas instead of or in addition to the supply tube 13.

### LIST OF REFERENCE SIGNS

- 1: EUV-radiation source
- 2: debris mitigation unit
- 3: collector mirror
- 4: vacuum vessel
- 5: intermediate focus
- 6: gas outlet
- 7: EUV radiation
- 8: central axis
- 9: straight pass
- 10: photodiode
- 11: multilayer mirror
- 12: bandpass filter
- 13: tube of gas supply unit
- 14: foil trap
- 15: photodiode
- 16: tube of gas supply unit
- 17: additional debris mitigation unit
- 18: tube

## Claims

1. Measurement setup for measuring radiation energy, in particular of EUV-radiation and/or soft X-rays, comprising a debris mitigation unit (2, 14, 17) with several passages allowing a straight pass of incoming radiation and a radiation-sensitive element (10, 15) delivering an electrical signal dependent on energy of incident radiation, said radiation-sensitive element (10, 15) being arranged to measure a fraction of said incoming radiation after passing said debris mitigation unit (2, 14, 17) at least partly,
**characterized in that** said debris mitigation unit (2, 14, 17) is mounted allowing a rotation around a central axis (8) of said debris mitigation unit (2, 14, 17) during operation and that said radiation-sensitive element (10, 15) and/or one or several mirrors (11) guiding said fraction of said radiation to said radiation-sensitive element (10, 15) is/are fixed to said rotating debris mitigation unit (2,14,17).

2. Measurement setup according to claim 1, **characterized in that** said mirrors (11) are multilayer mirrors.

3. Measurement setup according to claim 1 or 2, **characterized in that** one of said mirrors (11) is mounted on said central axis (8) for directing said fraction of said radiation to the radiation-sensitive element (10, 15) which is fixedly mounted in continuation of the central axis (8).

4. Measurement setup according to claim 1, **characterized in that** said debris mitigation unit (2, 14, 17) is a foil trap (14).

5. Measurement setup according to claim 4, **characterized in that** said foil trap (14) comprises a plurality of foils extending in a radial direction from said central axis (8).

6. Measurement setup according to claim 1 or 2, **characterized in that** the measurement setup further comprises a gas supply unit for supply of a gas inside said debris mitigation unit (2, 14, 17) and/or between said debris mitigation unit (2, 14, 17) and a radiation source emitting said radiation to slow down or stop debris particles by collisions with gas atoms.

7. Measurement setup according to claim 1 or 2, **characterized in that** said radiation-sensitive element (10, 15) is a photodiode.

8. EUV radiation unit having an EUV-radiation source (1) and illumination optics (3), wherein the measurement setup of one or several of the preceding claims is arranged to measure a fraction of radiation emitted by said EUV-radiation source (1).

9. EUV radiation unit according to claim 8, wherein the measurement setup is arranged between the EUV-radiation source (1) and the illumination optics (3) and dimensioned large enough to reduce an amount of debris moving to the illumination optics (3).

## Patentansprüche

1. Messeinrichtung zum Messen von Strahlungsenergie, insbesondere von EUV-Strahlung und/oder weicher Röntgenstrahlung, mit einer Debrisminderungseinheit (2, 14, 17) mit mehreren Durchgängen, die ein geradliniges Passieren der eintreffenden Strahlung erlauben, und einem strahlungsempfindlichen Element (10, 15), das abhängig von der Energie der auftreffenden Strahlung ein elektrisches Signal liefert, wobei das genannte strahlungsempfindliche Element (10, 15) vorgesehen ist, um einen Bruchteil der genannten eintreffenden Strahlung nach dem Passieren der genannten Debrisminderungseinheit (2, 14, 17) zumindest teilweise zu messen,
**dadurch gekennzeichnet, dass** die genannte Debrisminderungseinheit (2, 14, 17) so montiert ist, dass während des Betriebs eine Drehung um eine zentrale Achse (8) der genannten Debrisminderungseinheit (2, 14, 17) möglich ist, und dass das genannte strahlungsempfindliche Element (10, 15) und/oder ein oder mehrere Spiegel (11), die den genannten Bruchteil der genannten Strahlung auf das genannte strahlungsempfindliche Element (10, 15) leiten, an der genannten rotierenden Debrisminderungseinheit (2, 14, 17) befestigt sind.

2. Messeinrichtung nach Anspruch 1, **dadurch gekennzeichnet, dass** die genannten Spiegel (11) Mehrschichtspiegel sind.

3. Messeinrichtung nach Anspruch 1 oder 2, **dadurch gekennzeichnet, dass** einer der genannten Spiegel (11) an der genannten zentralen Achse (8) befestigt ist, um den genannten Bruchteil der genannten Strahlung auf das strahlungsempfindliche Element (10, 15) zu lenken, das fest in der Verlängerung der zentralen Achse (8) montiert ist.

4. Messeinrichtung nach Anspruch 1, **dadurch gekennzeichnet, dass** die genannte Debrisminderungseinheit (2, 14, 17) eine Folienfalle (14) ist.

5. Messeinrichtung nach Anspruch 4, **dadurch gekennzeichnet, dass** die genannte Folienfalle (14) eine Vielzahl von Folien umfasst, die sich in radialer Richtung von der genannten zentralen Achse (8) weg erstrecken.

6. Messeinrichtung nach Anspruch 1 oder 2, **dadurch gekennzeichnet, dass** die genannte Messeinrichtung weiterhin eine Gaszuführungseinheit zum Zuführen eines Gases innerhalb der genannten Debrisminderungseinheit (2, 14, 17) und/oder zwischen der genannten Debrisminderungseinheit (2, 14, 17) und einer die genannte Strahlung emittierenden Strahlungsquelle umfasst, um die Debrispartikel durch Kollision mit Gasatomen zu verlangsamen oder zu stoppen.

7. Messeinrichtung nach Anspruch 1 oder 2, **dadurch gekennzeichnet, dass** das genannte strahlungsempfindliche Element (10, 15) eine Fotodiode ist.

8. EUV-Strahlungseinheit mit einer EUV-Strahlungsquelle (1) und Beleuchtungsoptik (3), wobei die Messeinrichtung nach einem oder mehreren der vorhergehenden Ansprüche dafür vorgesehen ist, einen Bruchteil der durch die genannte EUV-Strahlungsquelle (1) emittierten Strahlung zu messen.

9. EUV-Strahlungseinheit nach Anspruch 8, wobei die Messeinrichtung zwischen der EUV-Strahlungsquelle (1) und der Beleuchtungsoptik (3) angeordnet ist und groß genug dimensioniert ist, um die sich zur Beleuchtungsoptik (3) bewegende Debrismenge zu reduzieren.

## Revendications

1. Dispositif de mesure pour mesurer de l'énergie de rayonnement, en particulier du rayonnement EUV et/ou des rayons X mous, comprenant une unité de réduction de débris (2, 14, 17) avec plusieurs passages qui permettent un passage droit du rayonnement entrant et un élément sensible au rayonnement (10, 15) fournissant un signal électrique en fonction de l'énergie du rayonnement incident, ledit élément sensible au rayonnement (10, 15) étant agencé de manière à mesurer une fraction dudit rayonnement entrant après le passage, au moins en partie, de ladite unité de réduction de débris (2, 14, 17),
**caractérisé en ce que** ladite unité de réduction de débris (2, 14, 17) est montée de manière à permettre une rotation autour d'un axe central (8) de ladite unité de réduction de débris (2, 14, 17) pendant le fonctionnement et **en ce que** ledit élément sensible au rayonnement (10, 15) et/ou un ou plusieurs miroirs (11) guidant ladite fraction dudit rayonnement vers ledit élément sensible au rayonnement (10, 15) est/sont fixés à ladite unité tournante de réduction de débris (2, 14, 17).

2. Dispositif de mesure selon la revendication 1, **caractérisé en ce que** lesdits miroirs (11) sont des miroirs en multicouche.

3. Dispositif de mesure selon la revendication 1 ou 2, **caractérisé en ce qu'**un desdits miroirs (11) est monté sur ledit axe central (8) pour diriger ladite fraction dudit rayonnement vers l'élément sensible au rayonnement (10, 15) qui est monté à demeure dans le prolongement de l'axe central (8).

4. Dispositif de mesure selon la revendication 1, **caractérisé en ce que** ladite unité de réduction de débris (2, 14, 17) est un piège de feuille (14).

5. Dispositif de mesure selon la revendication 4, **caractérisé en ce que** ledit piège de feuille (14) comprend une pluralité de feuilles qui s'étendent dans une direction radiale à partir dudit axe central (8).

6. Dispositif de mesure selon la revendication 1 ou 2, **caractérisé en ce que** le dispositif de mesure comprend encore une unité d'alimentation en gaz pour l'alimentation d'un gaz à l'intérieur de ladite unité de réduction de débris (2, 14, 17) et/ou entre ladite unité de réduction de débris (2, 14, 17) et une source de rayonnement qui émet ledit rayonnement pour ralentir ou pour arrêter des particules de débris par des collisions avec des atomes de gaz.

7. Dispositif de mesure selon la revendication 1 ou 2, **caractérisé en ce que** ledit élément sensible au rayonnement (10, 15) est une photodiode.

8. Unité de rayonnement EUV ayant une source de rayonnement EUV (1) et un système optique d'illumination (3), dans laquelle le dispositif de mesure d'une ou de plusieurs des revendications précédentes 1 à 7 est agencé de manière à mesurer une fraction du rayonnement qui est émis par ladite source de rayonnement EUV (1).

9. Unité de rayonnement EUV selon la revendication 8, dans laquelle le dispositif de mesure est disposé entre la source de rayonnement EUV (1) et le système optique d'illumination (3) et est dimensionné assez largement de manière à réduire une quantité de débris se déplaçant au système optique d'illumination (3).
